# EUROPÄISCHE PATENTSCHRIFT

(11) **EP 1 738 402 B1**
(45) Veröffentlichungstag und Bekanntmachung des Hinweises auf die Patenterteilung: **17.09.2008**
(21) Anmeldenummer: 05771164.0
(22) Anmeldetag: 21.07.2005
(51) Int. Cl.: H01L 21/225, H01L 21/268, H01L 31/18, B23K 26/073

(54) **LASERDOTIERUNG VON FESTKÖRPERN MIT EINEM LINIENFOKUSSIERTEN LASTERSTRAHL UND DARAUF BASIERENDE HERSTELLUNG VON SOLARZELLEN-EMITTERN**
LASER DOPING OF SOLID BODIES USING A LINEAR-FOCUSSED LASER BEAM AND PRODUCTION OF SOLAR-CELL EMITTERS BASED ON SAID METHOD
DOPAGE LASER D'ELEMENTS SOLIDES AU MOYEN D'UN FAISCEAU LASER A FOCALISATION LINEAIRE ET FABRICATION D'EMETTEURS DE CELLULES SOLAIRES BASEE SUR CE PROCEDE

(30) Priorität: 26.07.2004 DE 102004036220
(43) Veröffentlichungstag der Anmeldung: 03.01.2007
(73) Patentinhaber: Werner, Jürgen H., 70176 Stuttgart (DE); Köhler, Jürgen, 71332 Waiblingen (DE)
(72) Erfinder: WERNER, Jürgen H., 70176 Stuttgart (DE); KÖHLER, Jürgen, 71332 Waiblingen (DE); ESTURO-BRETON, Ainhoa, 70329 Stuttgart (DE)
(74) Vertreter: Patentanwälte Lambsdorff & Lange
(86) Internationale Anmeldenummer: PCT/DE2005/001280
(87) Internationale Veröffentlichungsnummer: WO 2006/012840

(56) Entgegenhaltungen:
- US-A- 3 420 719
- US-A- 3 640 782
- US-A- 4 147 563
- US-A- 4 370 175
- US-A- 4 436 557
- US-A- 5 538 564
- US-A1- 2002 191 301
- US-B1- 6 531 681

## Beschreibung

Die vorliegende Erfindung betrifft ein Verfahren zur Erzeugung eines dotierten Bereichs in einem Festkörper nach dem Oberbegriff des Patentanspruchs 1 und auf eine Vorrichtung zur Durchführung des Verfahrens. Die Erfindung bezieht sich ferner auf ein auf dem erfindungsgemäßen Verfahren beruhendes Verfahren zur Herstellung eines Emitterbereichs einer Solarzelle. Die Erfindung bezieht sich ferner auf ein auf dem erfindungsgemäßen Verfahren beruhendes Verfahren zur Herstellung eines ohmschen Kontakts zwischen einem Halbleiter und einem Metall.

Bei der kommerziellen Herstellung von Solarzellen aus einkristallinem oder multikristallinem Silizium wird der Solarzellen-Emitter durch einen Hochtemperaturschritt erzeugt. Hierbei erfolgt die Diffusion des Dotierstoffs, im Allgemeinen Phosphor, in einem Diffusionsofen bei einer Temperatur von ca. 1000 K. Die hierfür benötigte Zeitdauer beträgt ca. 30 Minuten. Die konventionelle Herstellung des Solarzellen-Emitters durch Diffusion in einem Diffusionsofen ist somit energie- und zeitaufwändig.

Darüber hinaus kann bei dem konventionellen Diffusionsprozess aufgrund der langen Prozesszeit für die Emitter-Diffusion die Fabrikation nur im Batch-Betrieb in einer Produktionsanlage durchgeführt werden. Eine kostengünstige Herstellung von Solarzellen erfordert jedoch einfache und schnelle Einzel-Prozessschritte, die sich in einen kontinuierlichen Fertigungsprozess, d.h. einen Inline-Prozess integrieren lassen. Die Herstellung des Solarzellen-Emitters durch Diffusion in einem Diffusionsofen erfüllt diese Anforderungen nicht.

Aus der Druckschrift US 5,918,140 ist ein Verfahren zur Laserdotierung von Halbleitern bekannt, bei welchem zuerst eine dünne Schicht eines einen Dotierstoff enthaltenden Materials auf die Oberfläche des Halbleiters aufgebracht wird. Dann wird die Halbleiter-Oberfläche mit gepulster Laserstrahlung beaufschlagt, wobei die Energie der Laserimpulse in dem Bereich der Grenzfläche zwischen der Halbleiter-Oberfläche und der aufgebrachten Dotierstoffschicht absorbiert und in thermische Energie umgewandelt wird. Der obere Bereich des Halbleiters wird dadurch aufgeschmolzen und während dieser Zeitdauer des Aufschmelzens diffundieren Dotierstoffatome in den aufgeschmolzenen Bereich des Halbleiters. Während und nach der Abfallzeit des Laserpulses rekristallisiert der zuvor aufgeschmolzene Bereich des Halbleiters, wobei die Dotierstoffatome in das Kristallgitter eingebaut werden. Auf diese Weise ist es prinzipiell möglich, oberflächennahe dotierte Bereiche hoher Dotierstoff-Konzentration in einem Festkörper zu erzeugen. Bisher ist es jedoch nicht möglich gewesen, die Laserdotierung eines Halbleiters wie Silizium derart durchzuführen, dass das Silizium in einer aufgeschmolzenen Oberflächenschicht mit einer Dicke von ca 1 µm oder weniger ohne Defekte rekristallisieren kann. Bei Versuchen wurden mit einem kommerziellen Laser-Bearbeitungssystem dotierte Bereiche in Silizium erzeugt, die anschließend als Solarzellen-Emitter eingesetzt wurden. Dabei zeigte sich, dass die Solarzellen-Emitter von sehr schlechter Qualität waren und dass insbesondere Leerlaufspannung und Wirkungsgrad der Solarzellen sehr niedrige Werte zeigen. Durch TEM-Untersuchungen zeigt sich darüber hinaus, dass die Solarzellen-Emitter vor allem durch eine hohe Versetzungsdichte geschädigt sind.

Die Druckschrift US-A-3,420,719 beschreibt ein Verfahren zur Erzeugung eines dotierten Bereichs in einem Festkörper, bei welchem eine einen Dotierstoff enthaltende Schicht auf ein Halbleiter-Substrat aufgebracht wird und durch Bestrahlung mit einem Laserstrahl im Dauerstrich-Betrieb ein Bereich des Substrats unterhalb der Oberfläche aufgeschmolzen wird, sodass der Dotierstoff in den aufgeschmolzenen Bereich eindiffundiert.

Die Druckschrift US-B1-6,531,681 beschreibt eine Vorrichtung und ein Verfahren zur Erzeugung von Strahlungsenergie zur Prozessierung eines Substrats oder darauf geformter integrierter Bauelemente oder Schaltkreise. Es wird unter anderem ausgeführt, dass als Strahlungsquelle ein gepulster Laser verwendet werden kann, wobei ausreichend Strahlungsenergie pro Puls benötigt wird, um eine ausreichende Temperatur in dem bearbeiteten Bereich des Substrats zu erreichen.

Die Druckschrift US-A-4,436,557 beschreibt ein Verfahren zur Erzeugung verbesserter elektronischer Bauelemente, welche elektronische Übergänge enthalten. Mittels Laser-Annealing werden in Silizium eingebrachte Fremdatome aktiviert und somit bestimmte Dotierungskonzentrationen im Silizium erzeugt. Es werden unter anderem Ausführungen zu der unterschiedlichen Temperaturbelastung bei gepulster Laserstrahlung und Dauerstrich-Laserstrahlung gemacht.

Die Druckschrift US 2002/191301 A1 beschreibt eine Vorrichtung zur Laserbestrahlung mit dem Ziel des Laser-Annealings von kristallinen Halbleiter-Oberflächen. Die beschriebene Vorrichtung weist eine gepulste Laserstrahlquelle, eine Zylinderlinse für die Erzeugung eines Linienfokus auf einer Halbleiter-Oberfläche und ein Objektiv für eine verkleinerte Abbildung des Linienfokus auf die Halbleiter-Oberfläche auf.

Es ist demzufolge Aufgabe der vorliegenden Erfindung, ein Verfahren zur Erzeugung eines dotierten Bereichs in einem Festkörper mittels Laserdotierung anzugeben, durch welches eine hohe Defektfreiheit des Festkörpers in dem dotierten Bereich erhalten werden kann oder mit welchem auf andere Weise die konventionellen Verfahren hinsichtlich der Bereitstellung der Dotierstoffschicht, der Erreichbarkeit hoher Dotierstoffkonzentrationen oder der Effizienz der Einkopplung der Laserstrahlleistung verbessert werden können.

Diese Aufgabe wird durch die kennzeichnenden Merkmale des Patentanspruchs 1 gelöst. Vorteilhafte Weiterbildungen und Ausgestaltungen sind Gegenstand von Unteransprüchen.

Bei dem erfindungsgemäßen Verfahren zur Erzeugung eines dotierten Bereichs in einem Festkörper wird zunächst ein Medium, welches einen Dotierstoff enthält, in Kontakt mit einer Oberfläche des Festkörpers gebracht. Anschließend wird durch Bestrahlung mit Laserimpulsen ein Bereich des Festkörpers unterhalb der mit dem Medium kontaktierten Oberfläche aufgeschmolzen, so dass der Dotierstoff in den aufgeschmolzenen Bereich eindiffundiert und während des Abkühlens der aufgeschmolzene Bereich rekristallisiert.

Ein wesentlicher Aspekt des erfindungsgemäßen Verfahrens besteht darin, dass der Laserstrahl in einem Linienfokus auf den Festkörper fokussiert wird. Dabei wird die Breite des Linienfokus kleiner als 10 µm gewählt. Beispielsweise kann die Fokusbreite in einem Bereich 5 µm bis 10 µm liegen. Die Fokusbreite kann aber auch etwa 5 µm oder darunter betragen.

Es hat sich mittlerweile bei Versuchen herausgestellt, dass sich durch die Bereitstellung eines Linienfokus für das Laserdotierverfahren rekristallisierte dotierte Bereiche hoher Defektfreiheit erzeugen lassen. Dies erreicht das erfindungsgemäße Verfahren ohne den Einsatz eines Hochtemperatur-Prozesses und ohne die Notwendigkeit langer Prozesszeiten. Vielmehr stellt das erfindungsgemäße Verfahren ein Niedertemperatur-Verfahren der Dotierung von Festkörpern dar, welches dotierte Bereiche hoher Kristallinität und Defektfreiheit erzeugt.

Das erfindungsgemäße Verfahren ermöglicht es somit, die bisherige tranchenweise Bearbeitung von Halbleiter-Wafern in Hochtemperaturöfen (Batch-Betrieb) abzulösen und durch einen logistisch effektiveren Inline-Prozess zu ersetzen und direkt in die Fertigungslinie von elektronischen Bauelementen wie Solarzellen zu integrieren

Bei den durchgeführten Versuchen wurde der Laserstrahl zu einer 5 µm breiten und mehrere 100 µm langen Linie geformt. Die Länge des Linienfokus liegt generell vorzugsweise in einem Bereich von 100 µm bis 10 mm.

Bei dem erfindungsgemäßen Verfahren kann die Tiefenausdehnung der zu dotierenden Bereiche durch geeignete Wahl der Wellenlänge des Lasers festgelegt werden. Dies geschieht dadurch, dass eine derartige Wellenlänge gewählt wird, dass die Absorptionslänge oder Eindringtiefe der Laserstrahlung in dem Festkörper der gewünschten Tiefenausdehnung des zu dotierenden Bereichs entspricht. Für Solarzellen-Emitter wird häufig eine Tiefenausdehnung von 1 µm oder weniger gewählt. Wenn der Festkörper der Halbleiter Silizium ist, so sollte demzufolge die Wellenlänge der Laserstrahlung 600 nm oder weniger betragen.

Des Weiteren sollte, wenn eine bestimmte Tiefenausdehnung des zu dotierenden Bereichs gewünscht wird, die Pulslänge derart gewählt werden, dass die Wärmediffusionslänge der Dotierstoffatome in dem aufgeschmolzenen Festkörper in der Größenordnung der gewünschten Tiefenausdehnung liegen. Wenn der Festkörper der Halbleiter Silizium ist und die gewünschte Tiefenausdehnung 1 µm beträgt, so sollte die Pulslänge unterhalb von 100 ns, insbesondere unterhalb von 50 ns liegen.

Im Normalfall soll ein Bereich dotiert werden, dessen laterale Ausdehnungen mindestens in einer Richtung größer als der Laserfokus sind, so dass das Strahlungsbündel über den Festkörper gerastert werden muss. Es wird eine Relativbewegung zwischen dem Festkörper und dem Strahlungsbündel erzeugt, welche senkrecht zur Linie des Linienfokus ausgerichtet ist. Vorzugsweise ist der Festkörper auf einem X-Y-Linear-Verschiebetisch montiert und der Laserstrahl bleibt stationär im Raum. Es kann jedoch auch vorgesehen sein, dass der Festkörper stationär bleibt und das optische System des Laserstrahls dafür ausgebildet ist, um den Laserstrahl über dem Festkörper zu rastern.

Das den Dotierstoff enthaltende Medium kann in Form einer flüssigen oder festen Beschichtung mittels eines Schleuderbeschichtungsverfahrens oder eines Siebdruck- oder Filmdruck-verfahrens auf die Grenzfläche aufgebracht werden. Es kann aber auch vorgesehen sein, dass das Medium gasförmig ist und mit der Oberfläche des Festkörpers direkt in Kontakt steht.

Eine Weiterbildung des erfindungsgemäßen Verfahrens besteht darin, dass das den Dotierstoff enthaltende Medium in Form einer festen Beschichtung durch ein Sputter-Verfahren auf den Festkörper aufgebracht wird, wobei der Laserstrahl beim späteren Aufschmelzen nicht notwendigerweise zu einem Linienfokus geformt werden muss. Es kann dabei vorgesehen sein, dass das Medium zunächst auf ein Startsubstrat aufgebracht wird, anschließend in einem ersten Sputter-Verfahrensschritt von dem Startsubstrat gesputtert und auf ein Zwischen-Target abgeschieden wird, und schließlich in einem zweiten Sputter-Verfahrensschritt von dem Zwischen-Target gesputtert und auf den zu dotierenden Festkörper abgeschieden wird.

Das Startsubstrat wie das Zwischen-Target können dabei jeweils durch Silizium-Substrate wie Silizium-Wafer gegeben sein. Das Medium kann im Wesentlichen oder zur Gänze aus dem Dotierstoff selbst bestehen und beispielsweise auf dem Startsubstrat pulverförmig aufgebracht werden. Insbesondere die üblicherweise vorgesehenen Dotierstoffelemente Phosphor, Arsen, Antimon, Bor, Aluminium, Gallium, Indium, Tantal oder Titan können also zunächst in Pulverform auf einen Silizium-Wafer abgeschieden werden und anschließend können diese Elemente von dem Silizium-Wafer auf das Zwischen-Target gesputtert werden. Die schließlich von dem Zwischen-Target auf den zu dotierenden Festkörper abgeschiedene Schicht kann somit zu über 90% aus dem Dotiermaterial bestehen, da beim Sputtern allenfalls in dem ersten Sputter-Verfahrensschritt geringe Mengen des Substrat-Siliziums mitgesputtert werden. Bei einer derartigen Verfahrensführung benötigt man somit nur eine sehr dünne, beispielsweise nur wenige Nanometer dicke Dotierschicht auf dem zu dotierenden Festkörper, um eine sehr hohe Dotierstoffkonzentration, beispielsweise bis zu 10²²/cm³ in dem Festkörper zu erzeugen.

Wenn in dieser Anmeldung von einem zu dotierenden Festkörper die Rede ist, so kann hiermit ein zu dotierender Halbleiter selbst gemeint sein. Es kann aber auch darunter verstanden werden, dass der Festkörper einen Hauptkörper, welcher der eigentliche zu dotierende Halbleiter-Körper ist, und eine auf eine Oberfläche des Hauptkörpers aufgebrachte Zwischenschicht enthält, wobei gemäß einem weiteren erfindungsgemäßen Verfahren das Medium auf der Zwischenschicht aufgebracht wird. Dabei ist nicht zwingend erforderlich, dass bei dem anschließenden Laserstrahldotieren der Laserstrahl zu einem Linienfokus geformt wird. Eine solche Ausführungsform ist beispielsweise dann gegeben, wenn auf den Halbleiter-Körper eine als Antireflexschicht für die Laserstrahlung wirkende Zwischenschicht aufgebracht wird. Durch die Antireflexschicht wird dafür gesorgt, dass die vollständige Lichtleistung der Laserstrahlung ausgenutzt und zum Aufschmelzen des unter der Zwischenschicht liegenden Oberflächenbereichs des Halbleiter-Körpers verwendet wird. Der Dotierstoff kann dann während des Aufschmelzens durch die Zwischenschicht in den Halbleiter-Körper diffundieren. Trotz der Zwischenschicht können auch auf diese Weise hohe Dotierstoffkonzentrationen in dem Halbleiter-Körper erzeugt werden, da insbesondere durch die oben beschriebenen Sputter-Verfahren zuvor sehr hohe Dotierstoffkonzentrationen auf der Zwischenschicht erzeugt werden können. Infolge des hohen Dotierstoff-Gradienten diffundiert der Dotierstoff auch durch die Zwischenschicht mit hoher Geschwindigkeit.

Die Zwischenschicht kann alternativ dazu oder auch zusätzlich als Passivierungsschicht zur Passivierung der Oberfläche, des Halbleiterkörpers ausgebildet sein.

Die Zwischenschicht kann insbesondere Siliziumnitrid, Siliziumdioxid oder amorphes Silizium enthalten oder aus einem dieser Materialien aufgebaut sein.

Die Zwischenschicht kann durch ein Sputter-Verfahren erzeugt werden. Insbesondere wenn die Dotierstoffschicht durch ein Sputter-Verfahren hergestellt wird, können Dotierstoffschicht und Zwischenschicht in ein und derselben Sputter-Anlage hergestellt werden.

Das erfindungsgemäße Verfahren kann insbesondere für die Herstellung eines Emitterbereichs einer Solarzelle verwendet werden, wobei durch das erfindungsgemäße Verfahren Bereiche einer Halbleiter-Oberfläche dotiert werden, die als Solarzellen-Emitter eingesetzt werden.

Das erfindungsgemäße Verfahren kann ferner auch für die Herstellung eines ohmschen Kontakts zwischen einem Halbleiter und einem Metall verwendet werden, wobei in einem Halbleiter ein dotierter Bereich nach dem erfindungsgemäßen Verfahren erzeugt wird und anschließend auf den dotierten Bereich eine metallische Schicht aufgebracht wird. Auf diese Weise können sowohl auf p-Typ- als auch auf n-Typ-Wafern ohmsche Kontakte mit sehr niedrigem Kontaktwiderstand erzeugt werden. Die in dieser Anmeldung beschriebenen Verfahren ermöglichen außerdem die Herstellung von Punktkontakten oder Streifenkontakten.

Eine Weiterbildung des erfindungsgemäßen Verfahrens bezieht sich darauf, dass eine gepulste Laserstrahlquelle, eine Zylinderlinse für die Erzeugung des Linienfokus und ein Objektiv für die verkleinerte Abbildung des Linienfokus auf die Oberfläche des Festkörpers verwendet werden.

Des Weiteren kann eine Autofokus-Vorrichtung verwendet werden, welche den Abstand der Festkörperoberfläche zu einem Referenzpunkt misst und den Abstand zwischen Objektiv und Festkörperoberfläche derart regelt, dass die Fokuslage innerhalb der Tiefenschärfe auf der Festkörperoberfläche bleibt. Dadurch wird sichergestellt, dass auch bei gekrümmten oder rauen Oberflächen die Fokuslage innerhalb der Tiefenschärfe auf der Wafer-Oberfläche gehalten werden kann.

Im Folgenden werden Ausführungsbeispiele für das erfindungsgemäße Verfahren dargestellt. Es zeigen:
- Fig. 1: ein Ausführungsbeispiel für die Durchführung des erfindungsgemäßen Verfahrens;
- Fig. 2a,b: ein Ausführungsbeispiel für die Durchführung des erfindungsgemäßen Verfahrens unter Verwendung eines zweistufigen Sputterverfahrens;
- Fig. 3: ein Ausführungsbeispiel für die Durchführung des erfindungsgemäßen Verfahrens mit einer zusätzlichen Antireflexschicht auf dem Halbleiter-Körper.

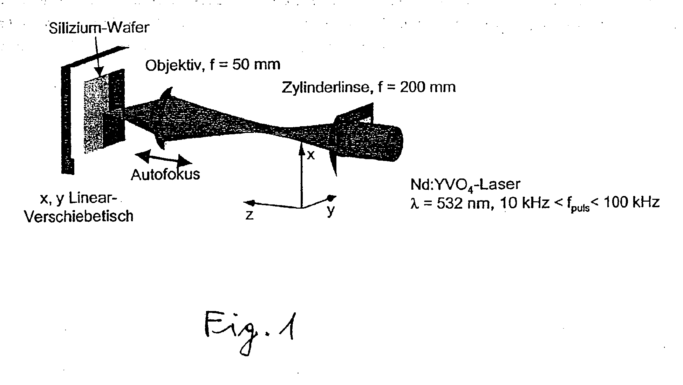

In der in der Fig. 1 dargestellten Vorrichtung wird als Laserstrahlquelle wird im vorliegenden Fall ein gütegeschalteter Nd:YVO₄-Laser verwendet, der durch Frequenzverdopplung Laserstrahlung bei einer Wellenlänge von λ = 532 nm emittiert. Die Pulsfrequenz liegt typischerweise in einem Bereich zwischen 10 kHz bis 100 kHz. Bei Laserdotierung von Silizium liegt die optimale Pulsenergiedichte im Bereich 2 bis 6 J/cm⁻².

Der Laserstrahl wird dann, gegebenenfalls nach einer Aufweitung, durch eine Zylinderlinse geführt, um einen Linienfokus zu erzeugen. Die Zylinderlinse weist im vorliegenden Fall eine Brennweite von f = 200 mm auf.

Schließlich wird der Laserstrahl durch ein Objektiv auf den Silizium-Wafer abgebildet. Das Objektiv weist im Ausführungsbeispiel eine Brennweite f = 50 mm auf. Durch das Objektiv wird der Linienfokus verkleinert auf den Silizium-Wafer abgebildet. Dabei muss dafür gesorgt werden, dass die Fokuslage selbst bei gekrümmten oder rauen Oberflächen ständig innerhalb der Tiefenschärfe der Abbildungsoptik auf der Wafer-Oberfläche bleibt. Dies kann durch eine Autofokus-Vorrichtung erreicht werden, die während des Prozesses ständig den Abstand der Wafer-Oberfläche zu einem Referenzpunkt misst und den Abstand zwischen Objektiv und Silizium-Wafer nachregelt. Im dargestellten Ausführungsbeispiel wird die Position des Objektivs bei dieser Nachregelung auf der Strahlachse verschoben. Es kann jedoch ebenso vorgesehen sein, dass die Position des Silizium-Wafers bei der Nachregelung auf der Strahlachse verschoben wird.

Der Silizium-Wafer ist auf einem X-Y-Linear-Verschiebetisch gehaltert, wobei die X-Y-Ebene senkrecht zu dem Laserstrahl liegt. Durch die Verschiebung des Silizium-Wafers gegenüber dem auftreffenden Strahlungsbündel kann ein größerer Bereich auf dem Silizium-Wafer abgerastert werden.

Bei Versuchen zur Herstellung von Solarzellen-Emittern wurde auf den Silizium-Wafer eine kommerzielle phosphorhaltige Dotierflüssigkeit durch ein Schleuderbeschichtungs-Verfahren mit Hilfe eines Spin-Coaters aufgebracht. Die Dotierung wird durch einen oder mehrere Laserpulse durchgeführt, wobei die Wafer-Oberfläche bis zu einer Tiefe von 1 µm oder weniger kurzzeitig aufgeschmolzen wird und Phosphor-Atome aus der Dotierflüssigkeit in das flüssige Silizium gelangen. Nach der Abkühlung und Verfestigung der Schmelze ist ein hochdotierter n-Typ-Emitterbereich fertiggestellt.

Es wurden auch bereits mit dem erfindungsgemäßen Verfahren Bor-dotierte p⁺-Typ-Emitter auf einem Si-n-Typ-Wafer prozessiert.

Das Strahlungsbündel wird vorzugsweise kontinuierlich mit vorgegebener Geschwindigkeit über die Wafer-Oberfläche geführt. Es wird vorher ermittelt, wie viele Laserimpulse für jeden Bereich der Oberfläche notwendig sind, um einen ausreichenden Dotierungsgrad zu erreichen. Aus dieser Anzahl und der Pulsfrequenz kann dann die Raster- oder Scan-Geschwindigkeit bestimmt werden. Vorzugsweise liegt die Scan-Geschwindigkeit in einem Bereich 0,1 bis 0,5 m/s. Alternativ dazu kann jedoch auch vorgesehen sein, den Verschiebetisch in diskontinuierlichen Schritten, die im Wesentlichen der Fokusbreite entsprechen, zu verfahren. An jedem angefahrenen Punkt, wird der Silizium-Wafer stationär mit einer vorgegebenen Anzahl von Laserimpulsen beaufschlagt und anschließend wird ohne Beaufschlagung mit Laserimpulsen der Linienfokus senkrecht zur Ausrichtung der Linie an einen nächsten Punkt gefahren.

Bei Verwendung eines 30-W-Lasersystems kann ein Durchsatz von ca. 10 cm²/s erreicht werden.

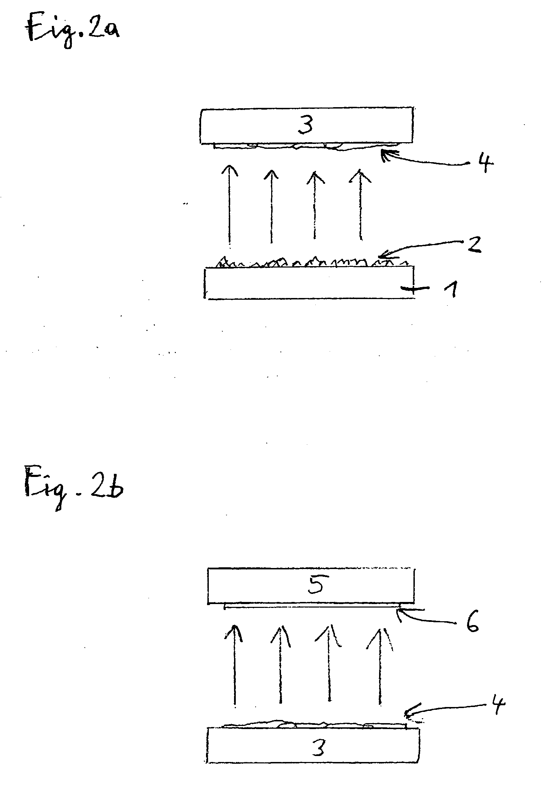

In der Fig. 2a,b ist eine Variante des erfindungsgemäßen Verfahrens dargestellt, bei welcher das Medium in Form einer festen Beschichtung durch ein zweistufiges Sputter-Verfahren auf den zu dotierenden Festkörper aufgebracht wird. Es wird zunächst ein Dotierstoff 2, beispielsweise reiner Phosphor, in Pulverform auf einen Silizium-Wafer 1 als Startsubstrat aufgebracht. Anschließend wird gemäß Fig. 2a in einem ersten Sputter-Verfahrensschritt der pulverförmige Dotierstoff 2 gesputtert und solchermaßen auf ein ebenfalls durch einen Silizium-Wafer gebildetes Zwischen-Target 3 aufgebracht und auf diesem Zwischen-Target 3 als Dotierstoffschicht 4 abgeschieden. Dadurch wird zunächst erreicht, dass eine zusammenhängende Dotierstoffschicht 4 bereitgestellt wird, welche beispielsweise eine Dotierstoffkonzentration von über 90% aufweisen kann. Außer dem Dotierstoff selbst, also beispielsweise Phosphor, kann in der Dotierstoffschicht 4 auch noch Silizium enthalten sein, welches in dem ersten Sputter-Verfahrensschritt von dem Silizium-Wafer 1 zusätzlich abgetragen wurde.

In einem zweiten Sputter-Verfahrensschritt gemäß Fig. 2b wird dann die Dotierstoffschicht 4 gesputtert und solchermaßen auf dem eigentlichen zu dotierenden Festkörper 5 in Form einer zweiten Dotierstoffschicht 6 abgeschieden. Diese Dotierstoffschicht 6 weist verglichen mit der Dotierstoffschicht 4 eine noch größere räumliche Homogenität in ihrer Materialzusammensetzung auf, sodass bei der anschließenden Laserstrahldotierung eine sehr homogene Dotierstoffverteilung in dem Festkörper 5 erreicht werden kann. Die Dotierstoffschicht 6 kann eine Dicke von wenigen nm, beispielsweise 1 - 10 nm aufweisen.

Anschließend wird der Laserstrahl auf den Festkörper 5 mit der aufgebrachten Dotierstoffschicht fokussiert und solchermaßen in einem Oberflächenbereich kurzzeitig zum Aufschmelzen gebracht, wobei nicht notwendigerweise ein Linienfokus verwendet werden muss. Der Dotierstoff der Dotierstoffschicht 6 diffundiert dann in den aufgeschmolzenen oberflächennahen Bereich des Festkörpers 5 ein und wird beim Rekristallisieren in das Gittergefüge des Festkörpers eingebaut.

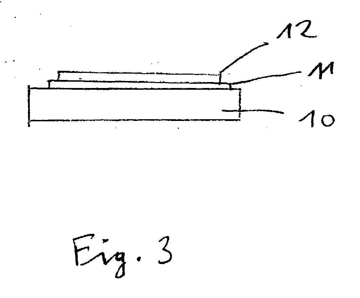

In der Fig. 3 ist eine weitere Variante des erfindungsgemäßen Verfahrens dargestellt, bei welcher auf einem Halbleiter-Körper wie etwa einem Silizium-Wafer 10 eine Antireflexschicht 11 oberhalb eines zu dotierenden Bereichs des Halbleiter-Körpers 10 aufgebracht wird. Die Antireflexschicht 11 ist so ausgebildet, dass die später für das Aufschmelzen verwendete Laserstrahlung einen möglichst niedrigen ReflexionsKoeffizienten erfährt, sodass deren Lichtleistung nahezu vollständig in den Halbleiter-Körper 10 eingekoppelt werden kann.

Auf die Antireflexschicht 11 wird dann ein den Dotierstoff enthaltendes Medium 12 aufgebracht. Das Medium kann beispielsweise selbst aus dem Dotierstoff bestehen und durch ein Sputter-Verfahren auf die Antireflexschicht 11 aufgebracht werden. Insbesondere durch ein, wie oben beschrieben, zweistufiges Sputter-Verfahren können solchermaßen Dotierelemente wie Phosphor oder dergleichen in hoher Konzentration auf die Antireflexschicht 11 aufgebracht werden. Die Antireflexschicht 11 kann ebenfalls durch ein Sputter-Verfahren, vorzugsweise in ein und derselben Sputter-Kammer, erzeugt werden.

Anschließend wird der Laserstrahl auf den Halbleiter-Körper 10 fokussiert und solchermaßen kurzzeitig in einem Oberflächenbereich zum Aufschmelzen gebracht, wobei nicht notwendigerweise ein Linienfokus verwendet werden muss. Der Dotierstoff diffundiert dann durch die Antireflexschicht 11 in den aufgeschmolzenen oberflächennahen Bereich des Halbleiter-Körpers 10 und wird beim Rekristallisieren in das Gittergefüge des Halbleiter-Körpers eingebaut.

Für besonders effiziente Solarzellen sind auch mehrstufige Emitter bekannt, die nach bisherigen Verfahren außerdem weitere Hochtemperaturprozesse sowie fotolithographische Strukturierungsverfahren erfordern. Durch das erfindungsgemäße Verfahren kann bei Verwendung eines Lasers mit relativ hoher Pulsfrequenz zusätzlich und gleichzeitig eine laterale Strukturierung der Dotierkonzentration zur Erzeugung mehrstufiger Emitter erfolgen.

Mithilfe des erfindungsgemäßen Verfahrens kann auch zusätzlich (oder für sich genommen) das sogenannte "back surface field" hergestellt werden, welches die Rekombination von Minoritätsträgern an der Rückseite verringert. Der Prozess ist wie oben beschrieben, wobei Bor-haltige Dotierpaste auf die Rückseite des p-Typ-Wafers aufgebracht und dann die Oberfläche mit dem Laser behandelt wird.

## Patentansprüche

1. Verfahren zur Erzeugung eines dotierten Bereichs in einem Festkörper, bei welchem
- ein Medium, welches einen Dotierstoff enthält, mit einer Oberfläche des Festkörpers in Kontakt gebracht wird,
- durch Bestrahlung mit Laserimpulsen ein Bereich des Festkörpers unterhalb der mit dem Medium kontaktierten Oberfläche aufgeschmolzen wird, so dass der Dotierstoff in den aufgeschmolzenen Bereich eindiffundiert und während des Abkühlens der aufgeschmolzene Bereich rekristallisiert,
wobei
- der Laserstrahl in einem Linienfokus auf den Festkörper fokussiert wird, und
- die Breite des Linienfokus kleiner als 10 µm beträgt.

2. Verfahren nach Anspruch 1,
**dadurch gekennzeichnet, dass**
- die Länge des Strichfokus im Bereich 100 µm bis 10 mm liegt.

3. Verfahren nach einem der vorhergehenden Ansprüche,
**dadurch gekennzeichnet, dass**
- die Wellenlänge des Lasers derart gewählt ist, dass die Absorptionslänge der Laserstrahlung in dem Festkörper einer vorgegebenen Länge, insbesondere 1 µm, entspricht.

4. Verfahren nach Anspruch 3,
**dadurch gekennzeichnet, dass**
- der Festkörper Silizium ist und die Wellenlänge der Laserstrahlung unterhalb von 600 nm liegt.

5. Verfahren nach einem der vorhergehenden Ansprüche,
**dadurch gekennzeichnet, dass**
- die Pulslänge derart gewählt ist, dass die Wärmediffusionslänge der Dotierstoffatome in dem aufgeschmolzenen Festkörper einer vorgegebenen Länge, insbesondere 1 µm, entspricht.

6. Verfahren nach Anspruch 5,
**dadurch gekennzeichnet, dass**
- der Festkörper Silizium ist und die Pulslänge unterhalb von 100 ns, insbesondere unterhalb von 50 ns, liegt.

7. Verfahren nach einem der vorhergehenden Ansprüche,
**dadurch gekennzeichnet, dass**
- das auftreffende Strahlungsbündel über die Oberfläche bewegt wird, indem eine Relativbewegung zwischen dem Strahlungsbündel und dem Festkörper erzeugt wird.

8. Verfahren nach einem der vorhergehenden Ansprüche,
**dadurch gekennzeichnet, dass**
- das Medium in Form einer flüssigen oder festen Beschichtung mittels eines Schleuderbeschichtungs-Verfahrens oder eines Siebdruck- oder Filmdruck-Verfahrens auf die Oberfläche aufgebracht wird.

9. Verfahren nach einem der vorhergehenden Ansprüche oder dem Oberbegriff des Anspruchs 1,
**dadurch gekennzeichnet, dass**
- das Medium in Form einer festen Beschichtung (6) durch ein Sputter-Verfahren aufgebracht wird.

10. Verfahren nach Anspruch 9,
**dadurch gekennzeichnet, dass**
- das Medium zuerst auf ein Startsubstrat (1) aufgebracht wird,
- in einem ersten Sputter-Verfahrensschritt von dem Startsubstrat (1) gesputtert und auf ein Zwischen-Target (3) abgeschieden wird, und
- in einem zweiten Sputter-Verfahrensschritt von dem Zwischen-Target (3) gesputtert und auf den zu dotierenden Festkörper (5) abgeschieden wird.

11. Verfahren nach Anspruch 10,
**dadurch gekennzeichnet, dass**
- das Zwischen-Target (3) ein Silizium-Substrat ist.

12. Verfahren nach Anspruch 10 oder 11,
**dadurch gekennzeichnet, dass**
- das Medium aus dem Dotierstoff besteht und auf dem Startsubstrat (1) pulverförmig aufgebracht wird.

13. Verfahren nach einem der vorhergehenden Ansprüche oder dem Oberbegriff des Anspruchs 1,
**dadurch gekennzeichnet, dass**
- der Festkörper einen Hauptkörper (10) und eine auf einer Oberfläche des Hauptkörpers (10) aufgebrachte Zwischenschicht (11) enthält und das Medium auf der Zwischenschicht (11) aufgebracht wird.

14. Verfahren nach Anspruch 13,
**dadurch gekennzeichnet, dass**
- die Zwischenschicht (11) eine Passivierungsschicht ist.

15. Verfahren nach Anspruch 13 oder 14,
**dadurch gekennzeichnet, dass**
- die Zwischenschicht (11) als Antireflexschicht für die Laserstrahlung wirkt.

16. Verfahren nach einem der Ansprüche 13 bis 15,
**dadurch gekennzeichnet, dass**
- die Zwischenschicht (11) Siliziumnitrid, Silizium-Dioxid oder amorphes Silizium enthält oder aus einem dieser Materialien aufgebaut ist.

17. Verfahren nach einem der Ansprüche 1 bis 16,
**dadurch gekennzeichnet, dass**
- der dotierte Bereich ein Emitterbereich einer Solarzelle ist.

18. Verfahren nach einem der Ansprüche 1 bis 17,
**dadurch gekennzeichnet, dass**
- auf den dotierten Bereich eine metallische Schicht aufgebracht wird.

19. Verfahren nach einem der Ansprüche 1 bis 18,
**dadurch gekennzeichnet, dass**
- eine Zylinderlinse für die Erzeugung des Linienfokus verwendet wird und ein Objektiv für die verkleinerte Abbildung des Linienfokus auf die Oberfläche des Festkörpers verwendet wird.

20. Verfahren nach Anspruch 19,
**dadurch gekennzeichnet, dass**
- eine Autofokus-Vorrichtung verwendet wird, welche den Abstand der Festkörperoberfläche zu einem Referenzpunkt misst und den Abstand zwischen Objektiv und Festkörperoberfläche derart regelt, dass die Fokuslage innerhalb der Tiefenschärfe auf der Festkörperoberfläche bleibt.

## Claims

1. A method of producing a doped region in solid-state material comprising
- bringing a medium containing a dopant into contact with a surface of the solid-state material,
- beaming a region of the solid-state material with laser pulses below the surface in contact with the medium to fuse said region so that the dopant diffuses into the fused region and the fused region recrystallizes during cooling
wherein
- the laser beam is focussed on the solid-state material in a line focus, and
- the line focus width is smaller than 10 µm.

2. The method as set forth in claim 1,
**characterized in that**
- the line focus length is in the range 100 µm to 10 mm.

3. The method as set forth in any of the preceding claims,
**characterized in that**
- the wavlength of the laser is selected such that the aborption length of the laser beam in the solid-state material corresponds to a predetermined length, particularly 1 µm.

4. The method as set forth in claim 3,
**characterized in that**
- the solid-state material is silicon and the wavlength of the laser beam is below 600 nm.

5. The method as set forth in any of the preceding claims,
**characterized in that**
- the pulse length is selected such that the thermal diffusion length of the dopant atoms in the fused solid-state material corresponds to a predetermined length, particularly 1 µm.

6. The method as set forth in claim 5,
**characterized in that**
- the solid-state material is silicon and the pulse length is below 100 ns, particularly below 50 ns.

7. The method as set forth in any of the preceding claims,
**characterized in that**
- the impinging beam pencil is moved over the surface by producing a relative movement between the beam pencil and the solid-state material.

8. The method as set forth in any of the preceding claims,
**characterized in that**
- the medium is deposited in the form of a liquid or solid coating to the surface by means of a spin coating process or a screen or film printing process.

9. The method as set forth in any of the preceding claims or in accordance with the preamble of claim 1,
**characterized in that**
- the medium is deposited in the form of a solid coating (6) by a spittering process.

10. The method as set forth in claim 9,
**characterized in that**
- the medium is first deposited on a starting substrate (1),
- then sputtered in a first step from the starting substrate (1) and and deposited on an intermediate target (3), and
- then sputtered in a second step from the intermediate target (3) and deposited on the solid-state material (5) to be doped.

11. The method as set forth in claim 10,
**characterized in that**
- the intermediate target (3) is a silicon substrate.

12. The method as set forth in claim 10 or 11,
**characterized in that**
- the medium comprises a dopant deposited powdered on the starting substrate (1).

13. The method as set forth in any of the preceding claims or preamble of claim 1,
**characterized in that**
- the solid-state material comprises a main body (10) and an interlayer (11) deposited to the surface of the main body (10) and that the medium is deposited on the interlayer (11).

14. The method as set forth in claim 13,
**characterized in that**
- the interlayer (11) is a passivating layer.

15. The method as set forth in claim 13 or 14,
**characterized in that**
- the interlayer (11) acts as an antireflex layer for the laser beam.

16. The method as set forth in any of the claims 13 to 15,
**characterized in that**
- the interlayer (11) comprises silicon nitride, silicon dioxide or amorphous silicon or is based on one of these materials.

17. The method as set forth in any of the claims 1 to 16,
**characterized in that**
- the doped region is an emitter region of a solar cell.

18. The method as set forth in any of the claims 1 to 17,
**characterized in that**
- the doped region is metallized.

19. The method as set forth in any of the claims 1 to 18,
**characterized in that**
- a cylindrical lens is used for producing the line focus and an objective lens is used to scale down the image of the line focus on the surface of the solid-state material.

20. The method as set forth in claim 19,
**characterized in that**
- an autofocus device is used which senses the distance of the solid-state material surface from a reference point and controls the distance between objective lens and surface of the solid-state material so that the focal point remains within the depth of focus on the surface of the solid-state material.

## Revendications

1. Procédé pour générer une zone dopée dans un corps solide, dans lequel :
- une matière qui contient une substance de dopage est amenée en contact avec une surface du corps solide,
- une zone du corps solide en dessous de la surface contactée par la matière est fondue par irradiation avec des impulsions laser de telle sorte que la substance de dopage se diffuse à l'intérieur de la zone fondue et se recristallise pendant le refroidissement de la zone fondue,
sachant que
- le rayon laser est focalisé sur le corps solide dans un foyer linéaire, et
- la largeur du foyer linéaire est inférieure à 10 µm.

2. Procédé selon la revendication 1,
**caractérisé en ce que**
- la longueur du foyer linéaire se trouve dans la plage de 100 µm à 10 µm.

3. Procédé selon l'une des revendications précédentes,
**caractérisé en ce que**
- la longueur d'ondes du laser est choisie de telle sorte que la longueur d'adsorption du rayonnement laser dans le corps solide correspond à une longueur prescrite, en particulier de 1 µm.

4. Procédé selon la revendication 3,
**caractérisé en ce que**
- le corps solide est du silicium et **en ce que** la longueur d'ondes du rayonnement laser se trouve en dessous de 600 nm.

5. Procédé selon l'une des revendications précédentes,
**caractérisé en ce que**
- la longueur d'impulsion est choisie de telle sorte que la longueur de diffusion de chaleur des atomes de la substance de dopage dans le corps solide fondu correspond à une longueur prescrite, en particulier de 1 µm.

6. Procédé selon la revendication 5,
**caractérisé en ce que**
- le corps solide est du silicium et **en ce que** la longueur d'impulsion se trouve en dessous de 100 ns, en particulier en dessous de 50 ns.

7. Procédé selon l'une des revendications précédentes,
**caractérisé en ce que**
- le faisceau incident de rayonnements est déplacé sur la surface, **en ce qu'**un mouvement relatif est généré entre le faisceau de rayonnements et le corps solide.

8. Procédé selon l'une des revendications précédentes,
**caractérisé en ce que**
- la matière est apposée sur la surface sous la forme d'une enduction liquide ou solide au moyen d'un procédé d'enduction par centrifugeuse ou d'un procédé d'impression par sérigraphie ou d'impression au cadre.

9. Procédé selon l'une des revendications précédentes ou selon le préambule de la revendication 1,
**caractérisé en ce que**
- la matière est apposée sous la forme d'une enduction solide (6) par un procédé de pulvérisation cathodique (« sputter »).

10. Procédé selon la revendication 9,
**caractérisé en ce que**
- la matière est apposée tout d'abord sur un substrat de départ (1),
- la pulvérisation cathodique est effectuée au cours d'une première étape du procédé de pulvérisation cathodique depuis le substrat de départ (1) et est déposée sur une cible intermédiaire (3), et
- la pulvérisation cathodique est effectuée au cours d'une seconde étape du procédé de pulvérisation cathodique depuis la cible intermédiaire (3) et est déposée sur le corps solide à doper (5).

11. Procédé selon la revendication 10,
**caractérisé en ce que**
- la cible intermédiaire (3) est un substrat de silicium.

12. Procédé selon l'une ou l'autre des revendications 10 et 11,
**caractérisé en ce que**
- la matière est constituée d'une substance de dopage et est apposée sur le substrat de départ (1) sous forme pulvérulente.

13. Procédé selon l'une des revendications précédentes ou selon le préambule de la revendication 1,
**caractérisé en ce que**
- le corps solide contient un corps principal (10) et une couche intermédiaire (11) apposée sur une surface du corps principal (10) et **en ce que** la matière est apposée sur la couche intermédiaire (11).

14. Procédé selon la revendication 13,
**caractérisé en ce que**
- la couche intermédiaire (11) est une couche de passivation.

15. Procédé selon l'une ou l'autre des revendications 13 et 14,
**caractérisé en ce que**
- la couche intermédiaire (11) agit comme couche anti-reflet pour le rayonnement laser.

16. Procédé selon l'une des revendications 13 à 15,
**caractérisé en ce que**
- la couche intermédiaire (11) contient du nitrure de silicium, du dioxyde de silicium ou du silicium amorphe ou est créée à partir d'un de ces matériaux.

17. Procédé selon l'une des revendications 1 à 16,
**caractérisé en ce que**
- la zone dopée est une zone d'émetteur d'une cellule solaire.

18. Procédé selon l'une des revendications 1 à 17,
**caractérisé en ce que**
- une couche métallique est apposée sur la zone dopée.

19. Procédé selon l'une des revendications 1 à 18,
**caractérisé en ce que**
- une lentille cylindrique est utilisée pour la génération d'un foyer linéaire et **en ce qu'**un objectif est utilisé pour la reproduction rapetissée du foyer linéaire sur la surface du corps solide.

20. Procédé selon la revendication 19,
**caractérisé en ce que**
- un dispositif d'autofocus est utilisé, lequel mesure la distance entre la surface du corps solide et un point de référence et régule la distance entre un objectif et une surface du corps solide de telle sorte que la position du foyer reste à l'intérieur de la profondeur de champ sur la surface du corps solide.
